# EUROPEAN PATENT APPLICATION

(11) **EP 2 337 086 A1**
(43) Date of publication of application: **22.06.2011**
(21) Application number: 09814310.0
(22) Date of filing: 17.09.2009
(51) Int. Cl.: H01L 31/04

(54) **FABRICATION METHOD FOR A SOLAR CELL**

(30) Priority: 22.09.2008 JP 2008242541
(71) Applicant: Ulvac, Inc., Chigasaki-shi Kanagawa 253-8543 (JP)
(72) Inventor: YAMAMURO, Kazuhiro, Chigasaki-shi Kanagawa 253-8543 (JP); YUYAMA, Junpei, Chigasaki-shi Kanagawa 253-8543 (JP); SONG, Yibing, Chigasaki-shi Kanagawa 253-8543 (JP); AOYAGI, Hidekatsu, Chigasaki-shi Kanagawa 253-8543 (JP)
(74) Representative: Eisenführ, Speiser & Partner
(86) International application number: PCT/JP2009/004677
(87) International publication number: WO 2010/032465

(57) **Abstract**

Provided is a method of manufacturing a photovoltatic cell according to the present invention, the photovoltatic cell including a substrate, and a structure in which a first conductive layer, a photoelectric conversion layer and a second conductive layer are superposed on the substrate in this order; the structure is electrically separated by a predetermined size to form a plurality of compartment elements; and the compartment elements adjacent to each other are electrically connected to each other, the method including: a defect region specifying step of specifying a region in which a structural defect exists from the plurality of compartment elements; and a repairing step of irradiating the region or the periphery thereof with a laser beam to remove the structural defect, wherein the repairing step includes a step α of irradiating the structure with a first laser to remove or separate the region, and a step β of irradiating an end portion of the structure generated by the removal or separation with a second laser to clean the end portion, and wherein the second laser uses a laser obtained by defocusing the first laser so that a focus position thereof is away from the substrate.

## Description

### BACKGROUND OF THE INVENTION

### Field of the Invention

The present invention relates to a method of manufacturing a photovoltatic cell, and specifically relates to a technique for repairing a structural defect generated in a thin-film photovoltatic cell without causing the characteristics of degradation of the thin-film photovoltatic cell. This application claims priority from Japanese Patent Application No. 2008-242541 filed on September 22, 2008, the content of which is incorporated herein by reference in its entirety.

### Description of Related Art

In recent years, from the viewpoint of efficient use of energy, photovoltatic cells have become more widely used than ever before. Particularly, a photovoltatic cell in which a silicon single crystal is utilized has a high level of energy conversion efficiency per unit area. In the photovoltatic cell in which the silicon single crystal is utilized, a silicon wafer obtained by slicing a silicon single crystal ingot is used. Since a large amount of energy is required for manufacturing the ingot, the manufacturing cost thereof increases. Particularly, when one tries to realize the photovoltatic cell having a large area which is placed out of doors or the like by use of the silicon single crystal, as a matter of fact, the manufacturing cost considerably increases. Consequently, as a low-cost photovoltatic cell, a photovoltatic cell capable of being more inexpensively manufactured in which an amorphous silicon thin film is employed is in widespread use.

The amorphous silicon photovoltatic cell includes a semiconductor film of a layered structure which is referred to as a pin-junction in which the amorphous silicon film (i-type), that generates electrons and holes when receiving light, is interposed between p-type and n-type silicon films; and electrodes formed on both sides of the semiconductor film. The electrons and the holes generated by sunlight actively transfer due to a difference in the electrical potential between p-type and n-type semiconductors, and the transfer thereof is continuously repeated to thereby cause a difference in the electrical potential to be generated between the electrodes on both sides of the semiconductor film.

Such an amorphous silicon photovoltatic cell is, for example, produced as follows. First, a transparent electrode made of TCO (Transparent Conducting Oxide) or the like having an optical transparency is formed on a glass substrate, serving as the light-receiving surface side, as a first conductive layer. A semiconductor film made of amorphous silicon is formed on the first conductive layer as a photoelectric conversion layer, and an Ag thin film or the like serving as a back-side electrode is further formed on the photoelectric conversion layer as a second conductive layer. The amorphous silicon photovoltatic cell including a structure constituted by the first conductive layer, the photoelectric conversion layer and the second conductive layer has a small difference in the electrical potential between both sides of the semiconductor film just by uniformly forming each of the layers on the substrate with a large area, and also has a problem of the resistance thereof. For this reason, in the amorphous silicon photovoltatic cell, for example, the structure is electrically separated by a predetermined area and is formed into a plurality of compartment elements, and then the compartment elements adjacent to each other are electrically connected to each other. Specifically, a configuration is adopted in which a groove referred to as a scribing line is formed in the structure, uniformly formed on the substrate with a large area, by use of laser light or the like to thereby form a plurality of compartment elements having a longitudinal rectangular shape, and the compartment elements are electrically connected in series.

In the amorphous silicon photovoltatic cell having such a configuration, it is known that several structural defects are generated during the manufacturing steps thereof. For example, at the time of forming the amorphous silicon film, there may be a case where particles are mixed into the amorphous silicon film, or pin holes are generated. There may be a case where the first conductive layer (transparent electrode) and the second conductive layer (back-side electrode) are locally short-circuited therebetween due to these structural defects. In addition, when the structure is formed on the substrate and then is divided into a plurality of compartment elements by the scribing lines, there may also be a case where a metal film that forms the second conductive layer is molten along the scribing lines and reaches the first conductive layer, and thus the first conductive layer and the second conductive layer are locally short-circuited therebetween.

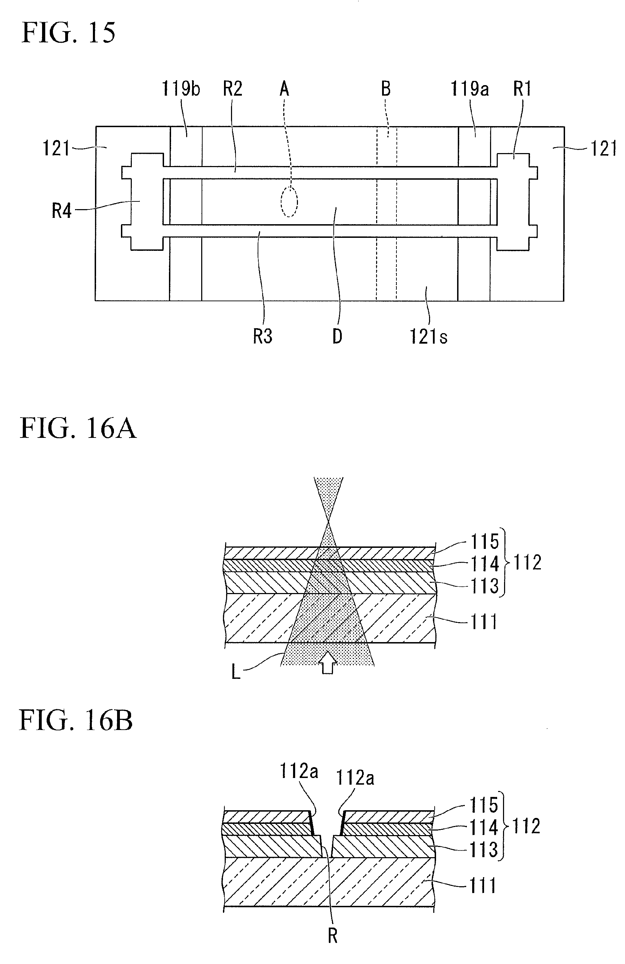

In this manner, when the structural defects are generated in the structure, such as the local short-circuiting between the first conductive layer and the second conductive layer which are disposed on both sides of the photoelectric conversion layer (semiconductor film), there occurs a malfunction such as a decrease in a power generation voltage of the amorphous silicon photovoltatic cell, or a decrease in power generation efficiency. Consequently, in a process for manufacturing a conventional amorphous silicon photovoltatic cell, the malfunction is repaired by detecting the structural defects that cause such a short circuit or the like, and removing the locations at which the structural defects are generated. In order to perform the repair by insulating the locations, in which such structural defects are generated, from the structure, as disclosed in, for example, Japanese Unexamined Patent Application, First Publication No. S59-94467, the locations are irradiated with a laser, to insulate the locations at which the structural defects are generated. On this occasion, as shown in FIG. 15, repair lines (R1 to R4) are formed in which two layers of the photoelectric conversion layer and the second conductive layer are removed by performing irradiation with one type of a laser L from the substrate side. The repair lines (R1 to R4) are formed so as to cross (traverse) scribing lines 119 (119a, 119b), so that a structural defect A is removed or separated.

However, when the structural defect A is removed by crossing (traversing) the scribing lines 119 (119a, 119b) that cause the first conductive layer and the second conductive layer to electrically conduct with each other, an insulation effect in a region D at which the structural defect A is generated becomes weak, and thus it is difficult to reliably insulate the region D. Consequently, in order to reliably insulate the region D, it is necessary to remove three layers of a first conductive layer 113, a photoelectric conversion layer 114 and a second conductive layer 115 by using a technique as disclosed in, for example, Japanese Unexamined Patent Application, First Publication No. 2008-66453 (see FIGS. 16A and 16B). In addition, when the cause of the structural defect exists in the first conductive layer 113, the photoelectric conversion layer 114 and the second conductive layer 115 all have to be removed together with the first conductive layer 113 in order to repair the structural defect.

However, when operations for removing three layers of the first conductive layer 113, the photoelectric conversion layer 114 and the second conductive layer 115 that constitute a structure 112 are performed at one time through irradiation with the laser L as shown in FIG. 16A, there may be a case, as shown in FIG. 16B, where a portion of the first conductive layer 113 evaporated through irradiation with the laser L is attached, as a residue, to end portions 112a of the photoelectric conversion layer 114 and the second conductive layer 115 of the structure 112 in which the repair lines R are formed. There may be a concern that a portion of the evaporated first conductive layer 113 is attached to the end portions 112a of the photoelectric conversion layer 114 and the second conductive layer 115, which leads to the degradation of the characteristics of the photovoltatic cell due to a new structural defect.

### SUMMARY OF THE INVENTION

The present invention is made in view of the above-mentioned problems, and an object thereof is to provide a method of manufacturing a photovoltatic cell capable of reducing the degradation of the characteristics in the photovoltatic cell, when it is necessary to remove a photoelectric conversion layer and a second conductive layer all together with a first conductive layer through irradiation with a laser, in order to repair a structural defect by which the first conductive layer and the second conductive layer are locally short-circuited therebetween.

(1) Provided is a method of manufacturing a photovoltatic cell according to the present invention, the photovoltatic cell including a substrate, and a structure in which a first conductive layer, a photoelectric conversion layer and a second conductive layer are superposed on the substrate in this order; the structure is electrically separated by a predetermined area to form a plurality of compartment elements; and the compartment elements adjacent to each other are electrically connected to each other, the method including: a defect region specifying step of specifying a region in which a structural defect exists from the plurality of compartment elements; and a repairing step of irradiating the region or the periphery thereof with a laser beam to remove the structural defect, wherein the repairing step includes a step α of irradiating the structure with a first laser to remove or separate the region, and a step β of irradiating an end portion of the structure generated by the removal or separation with a second laser to clean the end portion, and wherein the second laser uses a laser obtained by defocusing the first laser so that a focus position thereof is away from the substrate.

(2) In the method of manufacturing a photovoltatic cell according to the above (1), it is preferable that the step β includes moving an irradiation position of the second laser in a planar direction of the substrate, and irradiating the end portion of the structure at the side in which the structural defect does not exist with the second laser.

(3) In the method of manufacturing a photovoltatic cell according to the above (2), it is preferable that the step β includes performing irradiation with a third laser, different from the first laser in frequency of a laser beam, which is defocused so that a focus position thereof is farther from the substrate than that of the first laser, instead of irradiation with the second laser.

(4) In the method of manufacturing a photovoltatic cell according to the above (1) or (2), it is preferable that before irradiation with the first laser, the step α further includes a step of irradiating the structure with a fourth laser defocused so that a focus position thereof is farther from the substrate than that of the first laser to form a groove portion, and wherein after formation of the groove portion, the groove portion of the structure is irradiated with the first laser.

In the method of manufacturing a photovoltatic cell according to the above (1), the structure is irradiated with the first laser, and the region in which the structural defect exists is removed or separated by removing three layers of the first conductive layer, the photoelectric conversion layer and the second conductive layer. Thereafter, the end portion of the structure formed through this irradiation with the first laser is irradiated with the second laser obtained by defocusing the first laser so that the focus position thereof is away from the substrate. By the defocusing, the second laser is changed to a condition in which only the photoelectric conversion layer and the second conductive layer can be removed. Consequently, since a new structural defect generated in the wall surface (end portion) of the photoelectric conversion layer through the irradiation with the first laser (attachment of the first conductive layer removed through the irradiation with the first laser) is removed through this irradiation with the second laser, the end portion of the structure can be cleaned. Therefore, even when it is necessary to remove the photoelectric conversion layer and the second conductive layer all together with the first conductive layer through the irradiation with a laser in order to repair the structural defect by which the first conductive layer and the second conductive layer are locally short-circuited therebetween, the degradation of the characteristics in the photovoltatic cell can be reduced.

### BRIEF DESCRIPTION OF THE DRAWINGS

FIG. 1 is an enlarged perspective view illustrating an example of a main section of a photovoltatic cell produced by a method of manufacturing a photovoltatic cell according to the present invention.
FIG. 2 is a cross-sectional view illustrating an example of a layered structure of the photovoltatic cell shown in FIG. 1.
FIG. 3 is a flowchart schematically illustrating the method of manufacturing the photovoltatic cell according to the present invention.
FIG. 4 is a cross-sectional view of a photovoltatic cell illustrating an example of an existing structural defect.
FIG. 5 is an explanatory diagram illustrating a condition of a defect region specifying step.
FIG. 6A is a diagram illustrating a first example of a defect repairing step according to the present invention.
FIG. 6B is a diagram illustrating an example of the defect repairing step.
FIG. 6C is a diagram illustrating an example of the defect repairing step.
FIG. 6D is a diagram illustrating an example of the defect repairing step.
FIG. 7A is a diagram illustrating a second example of the defect repairing step according to the present invention.
FIG. 7B is a diagram illustrating an example of the defect repairing step.
FIG. 7C is a diagram illustrating an example of the defect repairing step.
FIG. 8A is a diagram illustrating the continuation of the defect repairing step shown in FIGS. 7A to 7C.
FIG. 8B is a diagram illustrating the continuation of the defect repairing step shown in FIGS. 7A to 7C.
FIG. 9A is a diagram illustrating a third example of the defect repairing step according to the present invention.
FIG. 9B is a diagram illustrating an example of the defect repairing step.
FIG. 9C is a diagram illustrating an example of the defect repairing step.
FIG. 10A is a diagram illustrating the continuation of the defect repairing step shown in FIGS. 9A to 9C.
FIG. 10B is a diagram illustrating the continuation of the defect repairing step shown in FIGS. 9A to 9C.
FIG. 10C is a diagram illustrating the continuation of the defect repairing step shown in FIGS. 9A to 9C.
FIG. 11A is a diagram illustrating a fourth example of the defect repairing step according to the present invention.
FIG. 11B is a diagram illustrating an example of the defect repairing step.
FIG. 11C is a diagram illustrating an example of the defect repairing step.
FIG. 12A is a diagram illustrating the continuation of the defect repairing step shown in FIGS. 11A to 11C.
FIG. 12B is a diagram illustrating the continuation of the defect repairing step shown in FIGS. 11A to 11C.
FIG. 13A is a diagram illustrating a fifth example of the defect repairing step according to the present invention.
FIG. 13B is a diagram illustrating an example of the defect repairing step.
FIG. 13C is a diagram illustrating an example of the defect repairing step.
FIG. 14A is a diagram illustrating the continuation of the defect repairing step shown in FIGS. 13A to 13C.
FIG. 14B is a diagram illustrating the continuation of the defect repairing step shown in FIGS. 13A to 13C.
FIG. 14C is a diagram illustrating the continuation of the defect repairing step shown in FIGS. 13A to 13C.
FIG. 15 is a diagram illustrating an example of the defect repairing step of the related art.
FIG. 16A is a diagram illustrating another example of the defect repairing step of the related art.
FIG. 16B is a diagram illustrating an example of the defect repairing step.

### DETAILED DESCRIPTION OF THE INVENTION

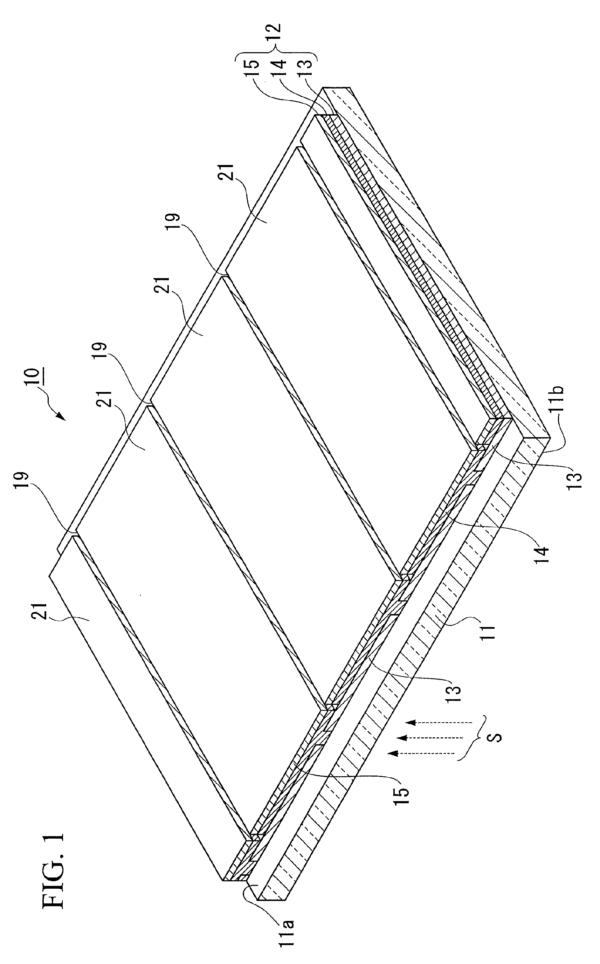

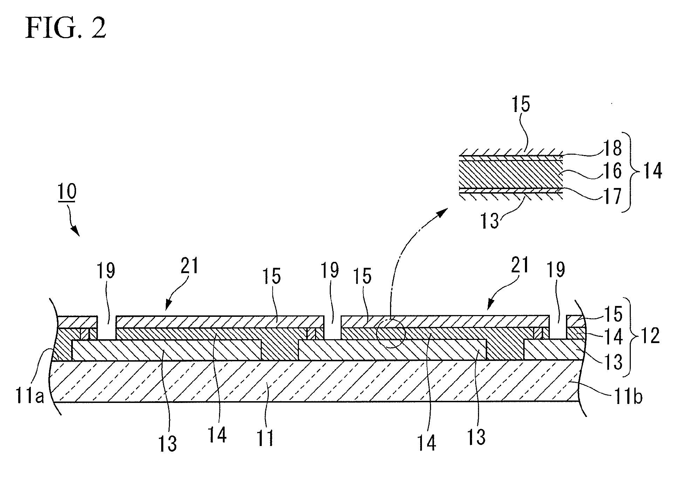

Hereinafter, an embodiment of a method of manufacturing a photovoltatic cell according to the present invention will be described taking the case of an amorphous silicon type photovoltatic cell as an example, with reference to the drawings. FIG. 1 is an enlarged perspective view illustrating an example of a main section of an amorphous silicon type photovoltatic cell which is manufactured by a method of manufacturing a photovoltatic cell according to the present invention. In addition, FIG. 2 is a cross-sectional view illustrating a layered structure of the photovoltatic cell shown in FIG. 1. A photovoltatic cell 10 shown in FIG. 1 includes an insulating substrate 11 having an optical transparency and a structure 12 formed on a first face 11a of the substrate 11.

The substrate 11 is formed of an insulation material, having a high level of sunlight transparency and durability, such as, for example, glass or a transparent resin. In this photovoltatic cell 10, sunlight S is incident on a second face 11b side of the substrate 11.

The structure 12 includes a first conductive layer (transparent electrode) 13 having an optical transparency, a photoelectric conversion layer 14, and a second conductive layer (back-side electrode) 15. That is, the structure 12 is formed by superposing the first conductive layer 13, the photoelectric conversion layer 14, and the second conductive layer 15 in this order.

The first conductive layer 13 is a TCO electrode formed of a metal oxide having an optical transparency, for example, TCO such as AZO [ZnO to which A1 (aluminum) is added] or GZO [ZnO to which Ga (gallium) is added], and ITO (Indium Tin Oxide).

For example, as shown in the upper portion of FIG. 2, the photoelectric conversion layer 14 includes a p-type amorphous silicon film 17, an n-type amorphous silicon film 18, and an i-type amorphous silicon film 16 interposed between the p-type amorphous silicon film 17 and the n-type amorphous silicon film 18, and forms a pin structure or a nip structure. The thickness of this photoelectric conversion layer 14 can be set to, for example, 2 to 300 nm. In addition, the photoelectric conversion layer 14 can also form a tandem structure in which a pin structure or a nip structure of microcrystal silicon is stacked on a pin structure or a nip structure of amorphous silicon.

When sunlight passing through the substrate 11 and the first conductive layer 13 is incident on this photoelectric conversion layer 14, and energetic particles contained in the sunlight reach the i-type amorphous silicon film 16, electrons and holes are generated by a photovoltatic effect. Then, due to a difference in the electrical potential between the p-type amorphous silicon film 17 and the n-type amorphous silicon film 18, the electrons move toward the n-type amorphous silicon film 18, and the holes move toward the p-type amorphous silicon film 17. This movement is actively continuously repeated, so that a difference in the electrical potential between the first conductive layer 13 and the second conductive layer 15 is generated. Light energy can be converted (photoelectric conversion) into electrical energy by extracting the electrons and the holes, respectively, from the first conductive layer 13 and the second conductive layer 15.

The second conductive layer 15 may be formed of a conductive metal film such as Ag (silver) or Cu (copper). The thickness of this second conductive layer 15 can be set to, for example, 2 to 300 nm. In addition, the second conductive layer 15 can also form a stacked structure of TCO and a metal or an alloy. The TCO is, for example, AZO, GZO, or ITO and the like. The metal or the alloy is, for example, Ag or an Ag alloy [for example, Ag containing Sn (tin) and Au (gold)].

The structure 12 is divided into a plurality of compartment elements 21 of which, for example, the outer shape is longitudinally rectangular by scribing lines 19 formed in the second conductive layer 15 and the photoelectric conversion layer 14 at the lower layer thereof. These compartment elements 21 are electrically separated from each other, and are, for example, electrically connected in series between the compartment elements 21 adjacent to each other. In this way, a difference in the electrical potential in the structure 12 increases, and more electrical current can be extracted.

The scribing lines 19 may be formed, for example, by removing the second conductive layer 15 and the photoelectric conversion layer 14 by a laser or the like and forming grooves with a predetermined distance in the structure 12, after the structure 12 is uniformly formed on the first face of the substrate 11. It is preferable that a protective layer (not shown) made of an insulating resin or the like is further formed on the second conductive layer 15 included in the structure 12.

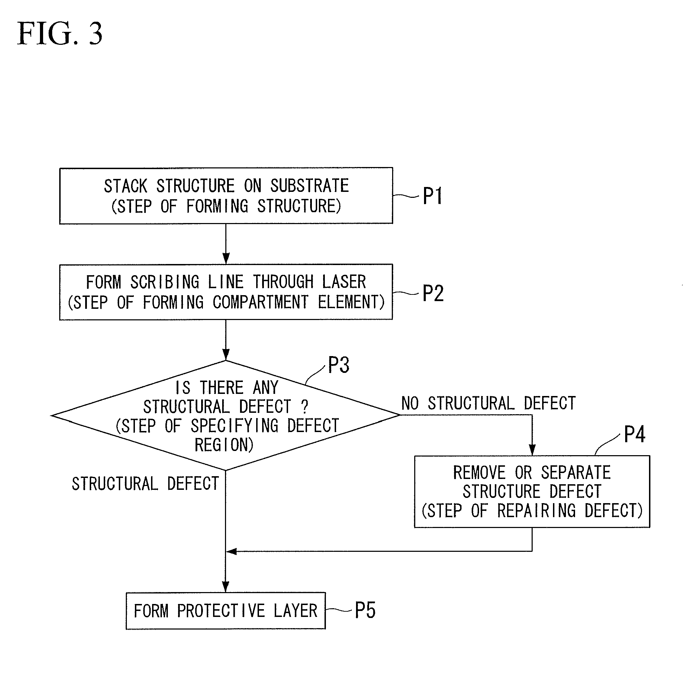

A method of manufacturing a photovoltatic cell having the foregoing configuration will be described. FIG. 3 is a flowchart illustrating a method of manufacturing the photovoltatic cell of the present invention in a stepwise manner. In the method, particularly, steps from a step of detecting a structural defect to a step of repairing will be described in detail.

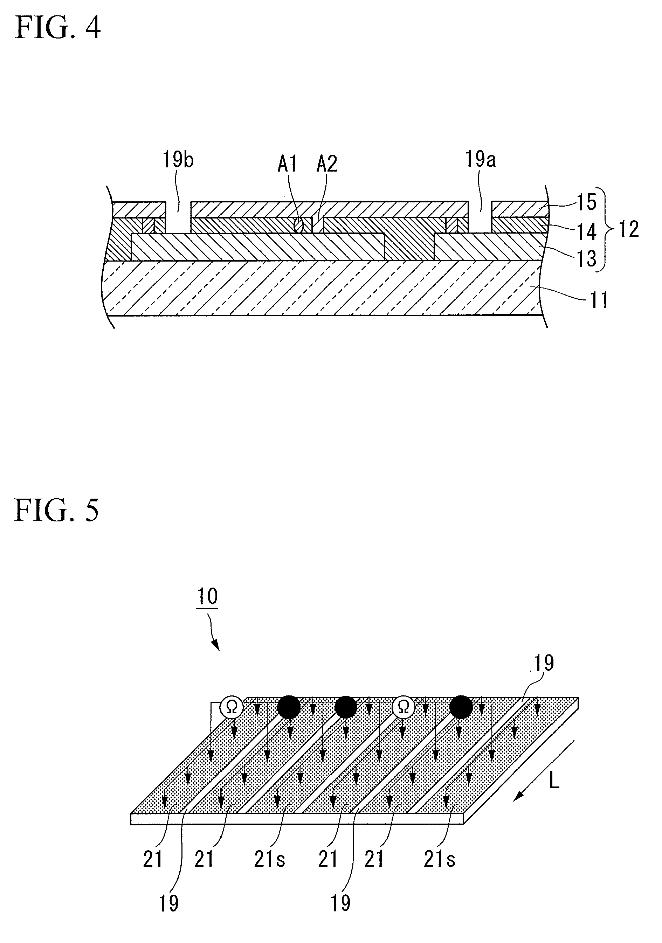

First, as shown in FIG. 1, the structure 12 is formed on the first face 11a of the transparent substrate 11 (structure formation step: P1). The structure 12 may be, for example, a structure in which the first conductive layer 13, the photoelectric conversion layer 14, and the second conductive layer 15 are stacked in order from the substrate 11 side. In the step of forming this structure 12, as shown in FIG. 4, there is a case where malfunction occurs, such as a structural defect A1 at which contamination is mixed in the photoelectric conversion layer 14 or a structural defect A2 at which microscopic pin holes are generated in the photoelectric conversion layer 14. These structural defects A (A1, A2) cause the first conductive layer 13 and the second conductive layer 15 to be locally short-circuited (leakage) therebetween, which results in degrading the power generation efficiency of the photovoltatic cell 10.

Next, the scribing lines 19 are formed by irradiating the structure 12, for example, with a laser or the like, and as shown in FIG. 1, the structure 12 is divided into a plurality of compartment elements 21 which are formed in a longitudinal rectangular shape (compartment element formation step: P2).

Next, the photovoltatic cell 10 formed through the steps as described above is completed through a defect region specifying step (P3) and a defect repairing step (P4) followed by a step (P5) of forming a protective layer or the like. In the defect region specifying step (P3), a region (defect region D) is specified in which the structural defects represented by the above-mentioned A1 to A2 exist within each of the compartment elements. In the defect repairing step (P4), the repair of the compartment elements (structure) is performed by removing or separating the regions in which the defects detected in this defect region specifying step exist. Hereinafter, specific examples of the foregoing defect region specifying step and the defect repairing step will be described.

### <Defect Region Specifying Step>

The defect region specifying step is not particularly limited insofar as defect locations are specified, but includes, for example, resistance measurement, FF (fill factor) measurement, imaging through a CCD camera or the like, and so forth.

As shown in FIG. 5, for example, when the compartment element 21s and the defect region D in which the structural defects exist are specify by the resistance measurement, several measuring points are set along the longitudinal direction L of the compartment element 21 formed in a longitudinal rectangular shape, and the resistance is measured between the compartment elements 21 adjacent to each other. Since the resistance lowers in the defect region D and the vicinity thereof, it is possible to specify the compartment element 21s and the defect region D in which the structural defects exist by observing the distribution (lowering in the resistance) of the measured values. Meanwhile, in FIG. 5, portions shown by a black circle are indicative of lowering in the resistance. When the structural defect exists in the compartment element 21 s, a gauge on the left side of the compartment element 21s is indicative of lowering in the resistance at one time of measuring the defect region D and the vicinity thereof.

On this occasion, by using a measuring apparatus in which a plurality of probes is arrayed along the longitudinal direction L of the compartment element 21 with a predetermined distance, the resistance measurement between the compartment elements 21 may be completed by moving the probe vertically. Alternatively, a measuring method may be used in which the probe is scanned along the longitudinal direction L of the compartment element 21 and the probe is repeatedly moved vertically at a predetermined measuring point, and so forth.

In the measurement of the resistance in such a defect region specifying step, any of methods may be used, such as a two-probe method, performed by two probes that constitute a pair, which is used for both applying a predetermined bias voltage and measuring an electrical current value, or a four-probe method, performed by four probes that constitute two pairs, in which probes used for applying a predetermined bias electrical current are different from probes used for measuring a voltage value. Each of the resistances is calculated based on the voltage value and the electrical current value.

In addition, as another detection method, a method of determining a plurality of threshold values of the resistances and changing the measurement interval between the terminals for each threshold value may be used. For example, the threshold values of the resistance are set to X, Y, and Z (here, X>Y>Z). By using a measuring apparatus in which a plurality of probes is arrayed along the longitudinal direction L of the compartment element 21 with a predetermined distance, the resistance is measured between the compartment elements 21 adjacent to each other. When the resistance obtained by the measurement is greater than or equal to the threshold value X, the next resistance is measured by the probe at a location spaced by ten probes from this measurement location. When the resistance obtained by the measurement is greater than or equal to the threshold value Y and less than or equal to the threshold value X, the next resistance is measured by the probe at a location spaced by five probes from this measurement location. When the resistance obtained by the measurement is greater than or equal to the threshold value Z and less than or equal to the threshold value Y, the resistance is measured by the probe at a location spaced by two probes from this measurement location. When the resistance obtained by the measurement is less than or equal to threshold value Z, the resistance is measured by each of the probes. When the measured value is high, conversely, the measurement is performed by increasing the measurement interval each time the resistance exceeds the threshold value. When the defects exist, the resistance obtained by the measurement gradually varies (decreases). Therefore, it is possible to quickly and accurately detect the positions of the defects by changing the measurement interval for each threshold value as described above.

Similarly, in defect region specifying step through the FF measurement, the FF values of the compartment elements adjacent to each other are compared, and a region in which the FF value is particularly reduced is specified as a region in which the structural defect exists.

The defect region specifying step through image capturing by a CCD camera is, for example, performed using the combination of a high-power lens with the CCD camera. The determination of the position of the structural defect from a captured image may be performed based on the visual determination by a person, or the comparison of, by a computer, image data of the compartment element of an object to be detected with image data of the compartment element having no defect which is previously image-captured.

After the above-mentioned defect region specifying step, the photovoltatic cell in which the region having the structural defect is found is transmitted to a defect repairing step as described next. On the other hand, the photovoltatic cell in which the compartment element having the structural defect is not found is determined as a non-defective product without modification, and is commercialized through a protective layer formation step P6 or the like. Meanwhile, a portion in which the structural defect exists can be specified in more detail by performing the above-mentioned defect region specifying step multiple times. On this occasion, the measurement is preferably performed so that a measurement interval of the resistance is smaller than the measurement interval of the resistance in the previous step.

In addition, the defect region can also be specified by the combination of the resistance measurement or the FF measurement, and image capturing by the CCD camera. First, the region in which the structural defect exists is specified by performing the resistance distribution or the FF measurement. Thereafter, the accurate position in which the structural defect exists within the compartment element 21 can be specified with a pinpoint by image-capturing the narrowed region using an image capturing measures such as the CCD camera.

The defect region specifying step through image capturing requires a lot of time when an object to be inspected has a large area. Therefore, in this case, after the region in which the structural defect exists is previously narrowed based on the distribution of the resistance measurable in a short time, the defect region specifying step through image capturing is performed only on this region having a small area. In this way, even when the object to be inspected has a large area, the accurate position of the structural defect can be specified quickly in a very short time.

### <Defect Repairing Step>

When the accurate position of the structural defect is specified in the compartment element 21, next, the structural defects A (A1, A2) of the photovoltatic cell are repaired (defect repairing step: P4). In this defect repairing step, the region D in which the structural defects A specified by the above-mentioned defect region specifying step exist is irradiated with a laser, and the first conductive layer 13, the photoelectric conversion layer 14, and the second conductive layer 15 in the region D in which the structural defects A exist are removed. Further, a new structural defect (first conductive layer attached to the wall surface (end portion) of the photoelectric conversion layer 14) generated by removing the first conductive layer through the irradiation with a laser is removed.

That is, the step of repairing the structural defects A (A1, A2) includes a step α of repeatedly irradiating the structure 12 with a first laser, and removing or separating the region D in which the structural defects specified in the defect region specifying step exist, and a step β of repeatedly irradiating the end portion of the structure 12 generated by the step α with a second laser obtained by defocusing the first laser so that a focus position of the first laser is away from the substrate 11 and cleaning the end portion of the structure 12.

In this defect repairing step, since the accurate positions of the structural defects A within the compartment element 21 are specified by the defect region specifying step, only the structure 12 in the minimum range including the structural defects A can be removed. Further, it is possible to perform the cleaning step of removing a new structural defect generated by removing the structural defects A.

This defect repairing step is performed by the following first to fifth defect repairing methods. In the first defect repairing method, the step α of irradiating the structure 12 with the first laser, followed by the step β of irradiating the structure 12 with the second laser without changing the laser irradiation position are performed. On this occasion, as the second laser, a laser obtained by defocusing the first laser is used so that the focus position of the first laser is away from the substrate 11. In the second defect repairing method, the step α of irradiating the structure 12 with the first laser, followed by the step β of irradiating the structure 12 with the second laser by changing the laser irradiation position are performed. On this occasion, as the second laser, the same laser as that in the first defect repairing method is used. In the third defect repairing method, the step α of irradiating the structure 12 with the first laser, followed by the step β of irradiating the structure with the second laser without changing the laser irradiation position are performed, and further irradiating the structure with the second laser by changing the laser irradiation position. On this occasion, as the second laser, the same laser as that in the first defect repairing method is used. In the fourth defect repairing method, the step α of irradiating the structure 12 with the first laser, followed by the step β of irradiating the structure with a third laser having a frequency different from that of the first laser by changing the laser irradiation position are performed. On this occasion, the focus position of the third laser is defocused so as to be farther from the substrate 11 than the focus position of the first laser. In the fifth defect repairing method, the step α of, before the structure 12 is irradiated with the first laser, irradiating the structure with a fourth laser, having a focus position different from that of the first laser, which is defocused so as to be away from the substrate 11, and irradiating the structure 12 with the first laser are performed, followed by the step β of irradiating the structure 12 with the second laser. On this occasion, as the second laser, the same laser as that in the first defect repairing method is used. Hereinafter, each of the methods will be described.

### [First Defect Repairing Method]

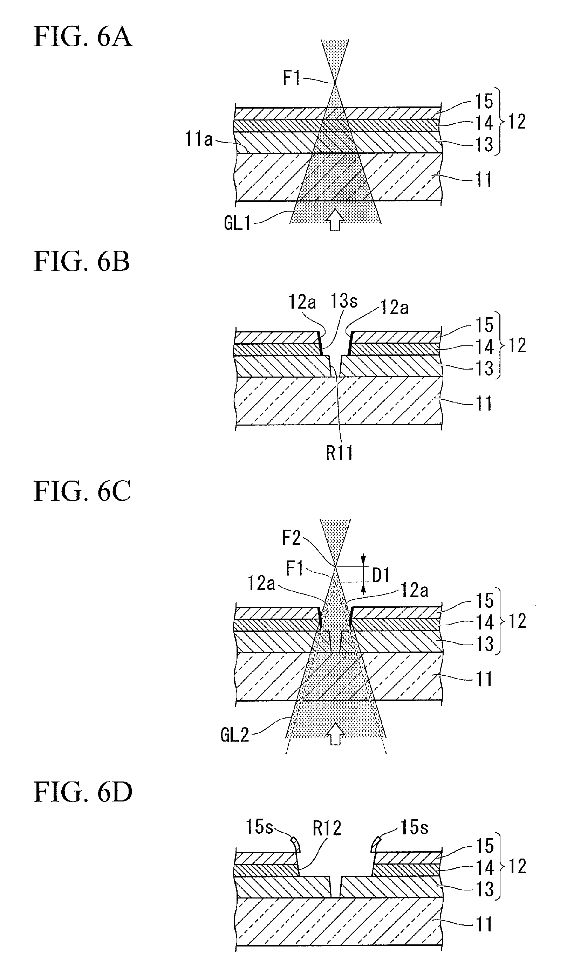

FIGS. 6A to 6D are diagrams schematically illustrating an example of steps of forming a repair line R1 for removing or separating a region in which the structural defect exists through laser irradiation, and then cleaning a new structural defect generated in the repair line R11. The structure 12 shown in FIGS. 6A to 6D is divided by scribing lines (not shown), into a plurality of compartment elements of which, for example, the outer shape is longitudinally rectangular.

First, as shown in FIG. 6A, the structure 12 is irradiated with the first laser GL1 from the substrate 11 side in a pulsed manner. This irradiation with the first laser GL1 is performed along the longitudinal direction of the compartment element 21 formed in a longitudinal rectangular shape. The first laser GL 1 is not particularly limited insofar as it can remove three layers of the first conductive layer 13, the photoelectric conversion layer 14, and the second conductive layer 15. For example, an SHG (Second Harmonic Generation) green laser can be used as the first laser. As shown in FIG. 6A, the focus position F1 of the first laser GL1 is located at the first face side 11a of the substrate 11, and is located at the position away from the structure 12. That is, the first laser GL1 is defocused with respect to the structure 12. In this way, as shown in FIG. 6B, the repair line R11 at which three layers constituting the structure 12 (first conductive layer 13, photoelectric conversion layer 14 and second conductive layer 15) are removed can be formed at one time.

The SHG laser is a laser oscillator that oscillates laser light of a laser second harmonic [twice the frequency (one-half of the wavelength) of the laser fundamental wave]. The SHG green laser is a laser oscillator that oscillates green light as the laser second harmonic. This SHG green laser includes a CO₂ laser, or a second harmonic of a YAG laser and the like. When the YAG laser is used, the wavelength of the green laser harmonic is 532 nm. Meanwhile, the green laser can be of course used as the first laser GL1 instead of the SHG laser.

However, when the three layers are removed at one time by the above-mentioned method, a portion 13s of the evaporated first conductive layer 13 is attached, as a residue, to the wall surface of a portion of the repair line R11, that is, the end portion 12a of the photoelectric conversion layer 14 and the second conductive layer 15, which results in a new structural defect. Consequently, as shown in FIG. 6C, while the end portion 12a of the photoelectric conversion layer 14 and the second conductive layer 15 is irradiated with the second laser GL2 in a pulsed manner, the second laser is moved along the longitudinal direction of the compartment element 21 formed in a longitudinal rectangular shape. At the time of laser irradiation, the irradiation position of the second laser GL2 is performed without changing from the irradiation position of the first laser GL1. As the second laser GL2, a laser obtained by defocusing the first laser GL1 is used so that the focus position F1 of the first laser GL1 is away from the substrate 11. That is, the focus position F2 of the second laser GL2 is farther from the substrate 11 (structure 12) than the focus position F1 of the first laser GL1. The defocus distance difference D1 indicating the difference between the focus position F1 of the first laser GL1 and the focus position F2 of the second laser GL2 is, for example, 1.0 mm.

In this manner, the irradiation condition of the second laser GL2 is changed to a condition capable of removing only the photoelectric conversion layer 14 and the second conductive layer 15 by using the second laser GL2 obtained by defocusing the first laser GL1. That is, in the second laser GL2 defocused as mentioned above, the energy of the laser with which the first conductive layer 13 is irradiated is smaller than the energy of the first laser GL1. For this reason, even when the irradiation with the second laser GL2 is performed, the first conductive layer 13 is not removed. Therefore, as shown in FIG. 6D, it is possible to newly form a repair line R12 at which the end portion 12a of the photoelectric conversion layer 14 and the second conductive layer 15, to which the portion 13s of the evaporated first conductive layer 13 is attached, is removed. On this occasion, as mentioned above, the second laser removes only the photoelectric conversion layer 14 and the second conductive layer 15. Therefore, a portion of the first conductive layer 13 is newly evaporated, and thus a portion of this evaporated first conductive layer 13 is not attached to the repair line R12 once again.

In this way, it is possible to effectively clean the end portion 12a of the photoelectric conversion layer 14 and the second conductive layer 15 to which the portion 13s of the first conductive layer 13 is attached by evaporation. Therefore, there is no concern that the portion 13s of the first conductive layer 13 attached to the end portion 12a of the photoelectric conversion layer 14 and the second conductive layer 15 causes the first conductive layer 13 and the second conductive layer 15 to be short-circuited therebetween. As a result, it is possible to prevent the characteristics of the photovoltatic cell from being degraded.

Gas generating materials that generate gas such as hydrogen by the laser irradiation are contained in the photoelectric conversion layer 14. For this reason, when the laser irradiation is performed in order to remove the portion 13s of the first conductive layer 13 attached to the end portion 12a of the photoelectric conversion layer 14 and the second conductive layer 15, the energy of this laser is absorbed by the photoelectric conversion layer 14, and high-pressure gas is generated from the above-mentioned gas generating materials. By using this high gas pressure, the second conductive layer 15 is also removed with removal of the photoelectric conversion layer 14.

However, in the case of the embodiment, since the second laser GL2 is defocused further than the first laser GL1 (the focus position F2 of the second laser GL2 is farther away from the structure 12 than the focus position F1 of the first laser), the energy density of laser light is reduced in the periphery of laser light. As a result, there is a concern about the generation of a burr 15s that causes a portion of the second conductive layer 15 not to be evaporated and remain on the end portion of the second conductive layer 15 of the repair line R12. Thereupon, a defect repairing method having no concern that a burr occurs will be described next as the second defect repairing method.

### [Second Defect Repairing Method]

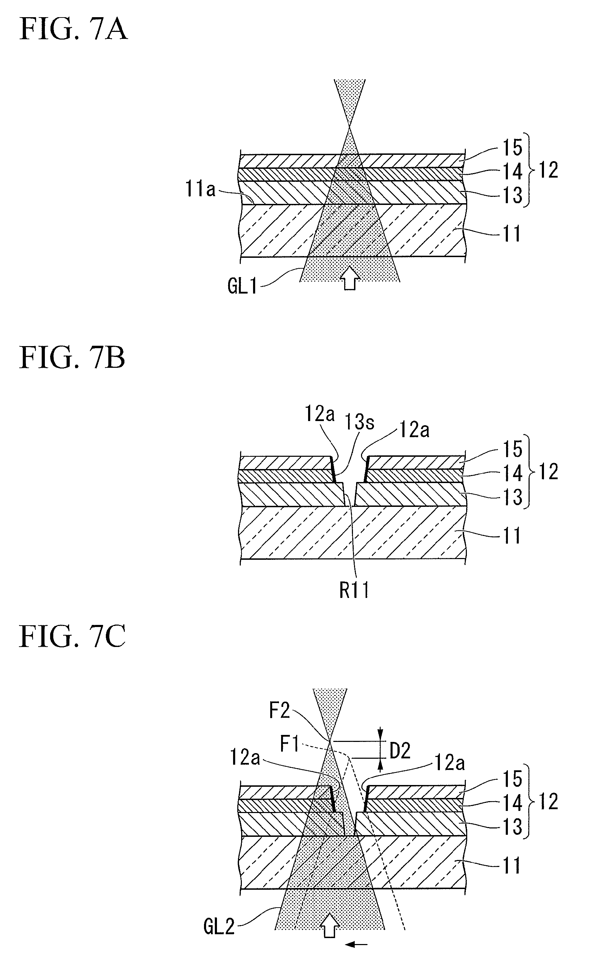

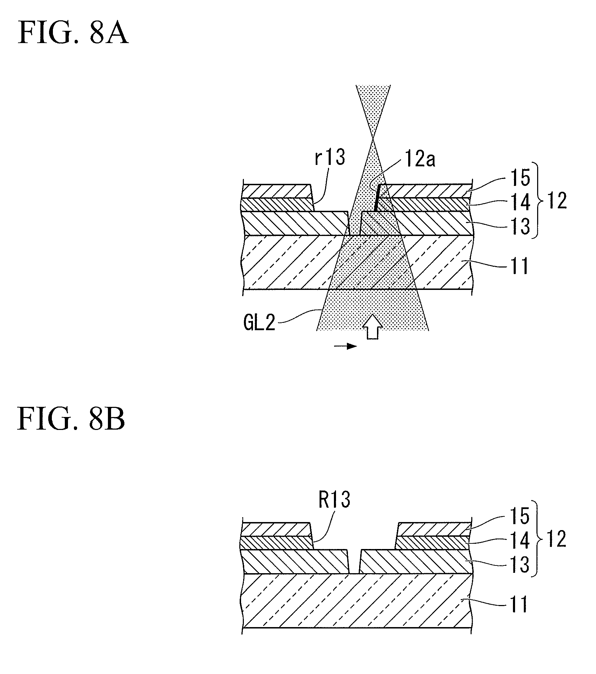

FIGS. 7A to 7C and FIGS. 8A to 8B are diagrams schematically illustrating an example of steps of forming the repair line R1 for removing or separating a region in which the structural defect exists through laser irradiation, and then cleaning a new structural defect generated in this repair line R1 through new laser irradiation. The structure 12 shown in FIGS. 7A to 7C and FIGS. 8A to 8B is also divided by scribing lines (not shown) into a plurality of compartment elements of which, for example, the outer shape is longitudinally rectangular.

First, as shown in FIG. 7A, the structure 12 is irradiated with the first laser GL1 from the substrate 11 side in a pulsed manner. The irradiation with the first laser GL1 is performed along the longitudinal direction of the compartment element 21 formed in a longitudinal rectangular shape. The first laser GL1 is not particularly limited insofar as it can remove three layers of the first conductive layer 13, the photoelectric conversion layer 14, and the second conductive layer 15. For example, an SHG green laser (green laser) can be used as the first laser. As shown in FIG. 7A, similarly to the above-mentioned first defect repairing method, the first laser GL1 is defocused in the first face 11a side of the substrate 11 so that the focus position F1 thereof is away from the structure 12. Meanwhile, the green laser can of course be used as the first laser GL1 instead of the SHG laser. In this way, as shown in FIG. 7B, the repair line R11 at which three layers constituting the structure 12 (first conductive layer 13, photoelectric conversion layer 14 and second conductive layer 15) are removed can be formed at one time.

However, when the three layers are removed at one time by the above-mentioned method, the portion 13s of the evaporated first conductive layer 13 is attached, as a residue, to the wall surface of a portion of the repair line R11, that is, the end portion 12a of the photoelectric conversion layer 14 and the second conductive layer 15, which results in a new structural defect. Consequently, as shown in FIG. 7C, while the end portion 12a of the photoelectric conversion layer 14 and the second conductive layer 15 is irradiated with the second laser GL2 in a pulsed manner, the second laser is moved along the longitudinal direction of the compartment element 21 formed in a longitudinal rectangular shape. On this occasion, as shown by a solid arrow in FIG. 7C, the irradiation position of the second laser GL2 is moved in the planar direction of the substrate 11, and the laser irradiation is performed. As the second laser GL2, a laser obtained by defocusing the first laser GL1 is used so that the focus position F1 of the first laser GL1 is away from the substrate 11. That is, the focus position F2 of the second laser GL2 is farther from the substrate 11 (structure 12) than the focus position F1 of the first laser GL1. The defocus distance difference D2 indicating the difference between the focus position F1 of the first laser GL1 and the focus position F2 of the second laser GL2 is, for example, 1.0 mm.

In that case, as shown in FIG. 8A, in the end portions 12a of the photoelectric conversion layer 14 and the second conductive layer 15 to which the portion 13s of the evaporated first conductive layer 13 is attached, a repair line r13 in which only one end portion is removed can be formed. Further, as shown in FIG. 8A, the irradiation position of the second laser GL2 is moved in the planar direction of the substrate 11 (in the planar direction opposite to that shown in FIG. 7C) as shown by a solid arrow in the same drawing, and the other end portion 12a of the photoelectric conversion layer 14 and the second conductive layer 15 is irradiated with laser light in a pulsed manner, while the irradiation position of the second laser GL2 is moved along the longitudinal direction of the compartment element 21 formed in a longitudinal rectangular shape. Meanwhile, this irradiation with the second laser GL2 may be performed on the end portion 12a of the photoelectric conversion layer 14 and the second conductive layer 15 of the compartment element at the side in which at least the structural defect does not exist.

In that case, as shown in FIG. 8B, it is possible to newly form a repair line R13 at which the other end portion 12a of the photoelectric conversion layer 14 and the second conductive layer 15, to which the portion 13s of the evaporated first conductive layer 13 is attached, is also removed. On this occasion, similarly to the above-mentioned first defect repairing method, the second laser GL2 is in a condition to remove only the photoelectric conversion layer 14 and the second conductive layer 15. Therefore, a portion of the first conductive layer 13 is newly evaporated, and thus a portion of this evaporated first conductive layer 13 is not attached to the repair line R13 once again.

In this way, it is possible to more effectively clean the end portion 12a of the photoelectric conversion layer 14 and the second conductive layer 15 to which the portion 13s of the first conductive layer 13 is attached by evaporation, without generating a burr that causes a portion of the second conductive layer 15 not to be evaporated and remain on the end portion (end portion of the second conductive layer 15) of the repair line. Therefore, it is possible to eliminate the concern that the portion 13s of the first conductive layer 13 attached to the wall surface of a portion of the repair line, that is, the end portion 12a of the photoelectric conversion layer 14 and the second conductive layer 15 causes the first conductive layer 13 and the second conductive layer 15 to be short-circuited therebetween. As a result, it is possible to prevent the characteristics of the photovoltatic cell from being degraded.

### [Third Defect Repairing Method]

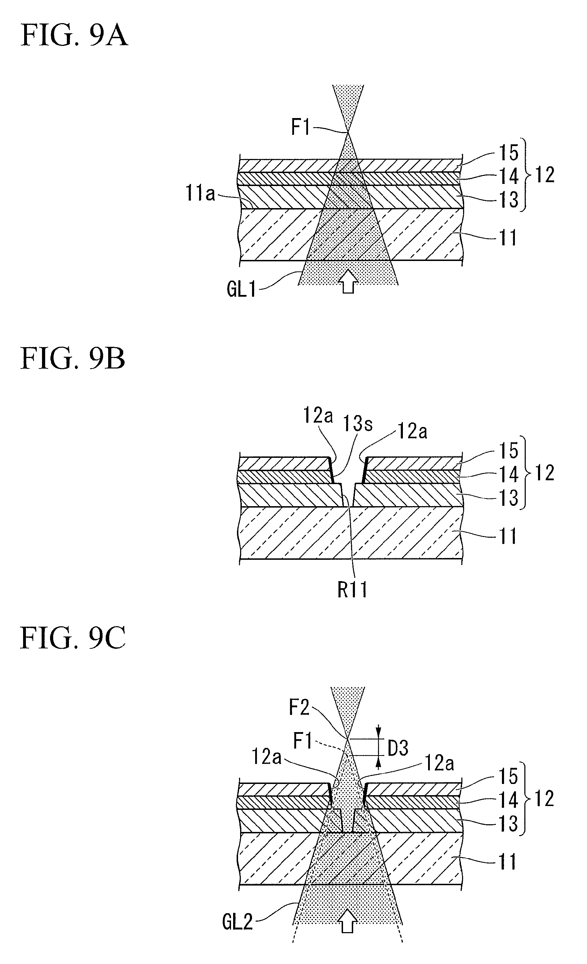

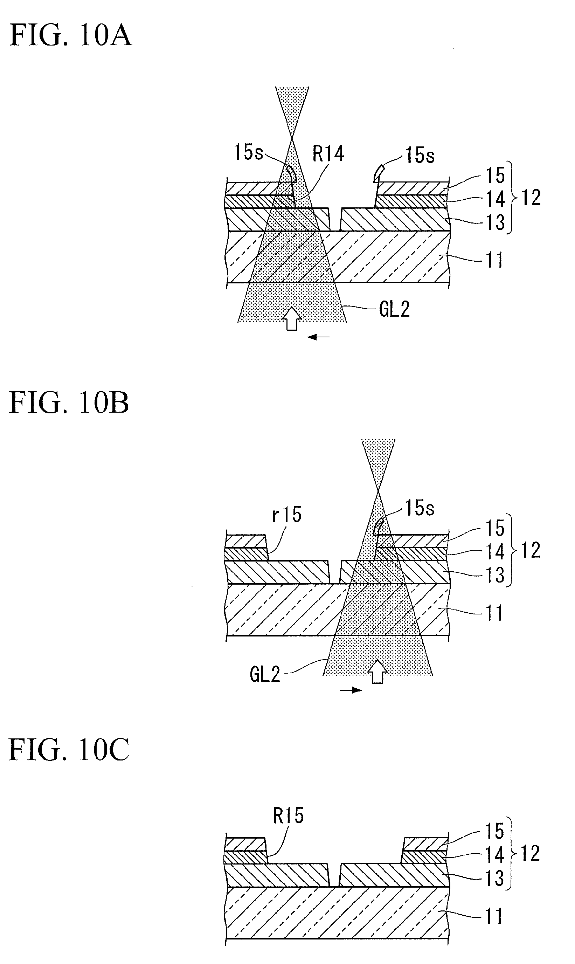

FIGS. 9A to 9C and FIGS. 10A to 10C are diagrams schematically illustrating another example of steps of forming the repair line R1 for removing or separating a region in which the structural defect exists through laser irradiation, and then cleaning a new structural defect generated in this repair line R11 through new laser irradiation. The structure 12 shown in FIGS. 9A to 9C and FIGS. 10A to 10C is also divided by scribing lines (not shown) into a plurality of compartment elements of which, for example, the outer shape is longitudinally rectangular.

First, as shown in FIG. 9A, the structure 12 is irradiated with the first laser GL1 from the substrate 11 side in a pulsed manner. This irradiation with the first laser GL1 is performed along the longitudinal direction of the compartment element 21 formed in a longitudinal rectangular shape. The first laser GL 1 is not particularly limited insofar as it can remove three layers of the first conductive layer 13, the photoelectric conversion layer 14, and the second conductive layer 15. For example, an SHG green laser (green laser) can be used as the first laser. As shown in FIG. 9A, similarly to the above-mentioned first defect repairing method, the first laser GL1 is defocused in the first face 11a side of the substrate 11 so that the focus position F1 thereof is away from the structure 12. Meanwhile, the green laser can be of course used as the first laser GL1 instead of the SHG laser. In this way, as shown in FIG. 9B, the repair line R11 at which three layers constituting the structure 12 (first conductive layer 13, photoelectric conversion layer 14, and second conductive layer 15) are removed can be formed at one time.

However, when the three layers are removed at one time by the above-mentioned method, the portion 13s of the evaporated first conductive layer 13 is attached, as a residue, to the wall surface of a portion of the repair line R11, that is, the end portion 12a of the photoelectric conversion layer 14 and the second conductive layer 15, which results in a new structural defect. Consequently, as shown in FIG. 9C, while the end portion 12a of the photoelectric conversion layer 14 and the second conductive layer 15 is irradiated with the second laser GL2 in a pulsed manner, the second laser is moved along the longitudinal direction of the compartment element 21 formed in a longitudinal rectangular shape. At the time of this laser irradiation, the irradiation position of the second laser GL2 is performed without changing the irradiation position of the first laser GL1. As the second laser GL2, a laser obtained by defocusing the first laser GL1 is used so that the focus position F1 of the first laser GL1 is away from the substrate 11. That is, the focus position F2 of the second laser GL2 is farther from the substrate 11 (structure 12) than the focus position F1 of the first laser GL1. The defocus distance difference D3 indicating the difference between the focus position F1 of the first laser GL1 and the focus position F2 of the second laser GL2 is, for example, 1.0 mm.

Through the irradiation with the second laser GL2, as shown in FIG. 10A, it is possible to newly form a repair line R14 at which the end portion 12a of the photoelectric conversion layer 14 and the second conductive layer 15, to which the portion 13s of the evaporated first conductive layer 13 is attached, is removed. However, there may be a case of the generation of the burr 15s that causes a portion of the second conductive layer 15 not to be evaporated and remain on the end portion of the second conductive layer 15. Consequently, subsequently, as shown in FIG. 10A, while one end portion 12a of the photoelectric conversion layer 14 and the second conductive layer 15 is irradiated with the second laser GL2 in a pulsed manner, the second laser is moved along the longitudinal direction of the compartment element 21 formed in a longitudinal rectangular shape. At the time of this laser irradiation, as shown by a solid arrow in FIG. 10A, the irradiation position of the second laser GL2 is moved in the planar direction of the substrate 11, and the laser irradiation is performed.

In that case, as shown in FIG. 10B, it is possible to form a repair line r15 at which only one side of the end portions 12a of the photoelectric conversion layer 14 and the second conductive layer 15, to which the portion 13s of the evaporated first conductive layer 13 is attached, is removed. Further, subsequently, as shown in FIG. 10B, the irradiation position of the second laser GL2 is moved in the planar direction of the substrate 11 (in the planar direction opposite to that shown in FIG. 10A) as shown by a solid arrow in the same drawing, and the other end portion 12a of the photoelectric conversion layer 14 and the second conductive layer 15 is irradiated in a pulsed manner, while the irradiation position of the second laser GL2 is moved along the longitudinal direction of the compartment element 21 formed in a longitudinal rectangular shape. Meanwhile, this irradiation with the second laser GL2 may be performed in the end portion 12a of the photoelectric conversion layer 14 and the second conductive layer 15 of the compartment element at the side in which at least the structural defect does not exist.

In that case, as shown in FIG. 10C, it is possible to newly form a repair line R15 at which the other end portion 12a of the photoelectric conversion layer 14 and the second conductive layer 15, to which the portion 13s of the evaporated first conductive layer 13 is attached, is also removed. On this occasion, similarly to the above-mentioned first and second defect repairing methods, the second laser is in a condition to remove only the photoelectric conversion layer 14 and the second conductive layer 15. Therefore, a portion of the first conductive layer 13 is newly evaporated, and thus a portion of this evaporated first conductive layer 13 is not attached to the repair line R15 once again.

In this way, it is possible to more cleanly clean the end portion 12a of the photoelectric conversion layer 14 and the second conductive layer 15 to which the portion 13s of the first conductive layer 13 is attached by evaporation, while removing the burr that causes a portion of the second conductive layer 15 not to be evaporated and remain on the end portion (end portion of the second conductive layer 15) of the repair line. Therefore, it is possible to eliminate the concern that the portion 13s of the first conductive layer 13 attached to the wall surface of a portion of the repair line, that is, the end portion 12a of the photoelectric conversion layer 14 and the second conductive layer 15 causes the first conductive layer 13 and the second conductive layer 15 to be short-circuited therebetween. As a result, it is possible to prevent the characteristics of the photovoltatic cell from being degraded.

### [Fourth Defect Repairing Method]

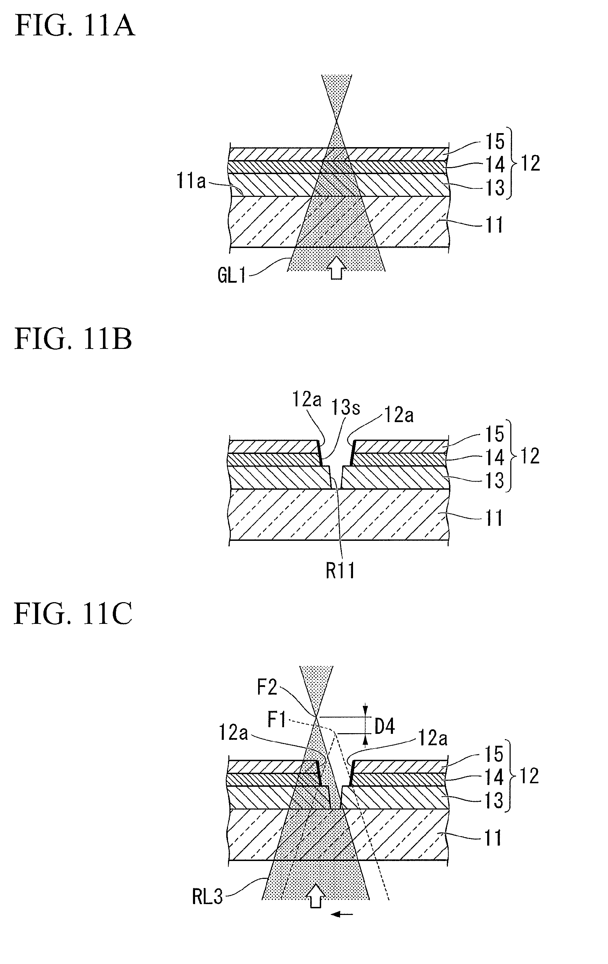

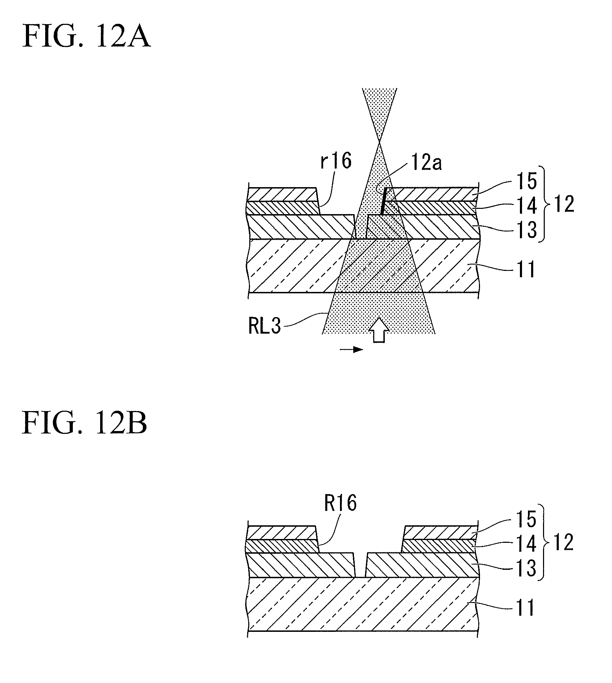

FIGS. 11A to 11C and FIGS. 12A to 12B are diagrams schematically illustrating another example of steps of forming the repair line R11 for removing or separating a region in which the structural defect exists through laser irradiation, and then cleaning a new structural defect generated in this repair line R11 through new laser irradiation. The structure 12 shown in FIGS. 11A to 11C and FIGS. 12A to 12B is also divided by scribing lines (not shown) into a plurality of compartment elements of which, for example, the outer shape is longitudinally rectangular.

First, as shown in FIG. 11A, the structure 12 is irradiated with the first laser GL1 from the substrate 11 side in a pulsed manner. This irradiation with the first laser GL1 is performed along the longitudinal direction of the compartment element 21 formed in a longitudinal rectangular shape. The first laser GL1 is not particularly limited insofar as it can remove three layers of the first conductive layer 13, the photoelectric conversion layer 14, and the second conductive layer 15. For example, an SHG green laser (green laser) can be used as the first laser. As shown in FIG. 11A, similarly to the above-mentioned first defect repairing method, the first laser GL1 is defocused in the first face 11 a side of the substrate 11 so that the focus position F1 thereof is away from the structure 12. Meanwhile, the green laser can of course be used as the first laser GL1 instead of the SHG laser. In this way, as shown in FIG. 11B, the repair line R1 at which three layers constituting the structure 12 (first conductive layer 13, photoelectric conversion layer 14 and second conductive layer 15) are removed can be formed at one time.

However, when the three layers are removed at one time by the above-mentioned method, the portion 13s of the evaporated first conductive layer 13 is attached, as a residue, to the wall surface of a portion of the repair line R11, that is, the end portion 12a of the photoelectric conversion layer 14 and the second conductive layer 15, which results in a new structural defect. Consequently, as shown in FIG. 11C, while one end portion 12a of the photoelectric conversion layer 14 and the second conductive layer 15 is irradiated with the third laser GL3 in a pulsed manner, the third laser is moved along the longitudinal direction of the compartment element 21 formed in a longitudinal rectangular shape. On this occasion, as shown by a solid arrow in FIG. 11C, the irradiation position of the third laser GL3 is moved in the planar direction of the substrate 11, and the laser irradiation is performed. This third laser GL3 is different from the first laser GL1 in frequency, and a laser obtained by defocusing the first laser GL1 is used as the third laser so that the focus position F1 of the first laser GL1 is away from the substrate 11. That is, the focus position F2 of the third laser GL3 is farther from the substrate 11 (structure 12) than the focus position F1 of the first laser GL1. The defocus distance difference D4 indicating the difference between the focus position F1 of the first laser GL1 and the focus position F2 of the third laser GL3 is, for example, 1.0 mm. In that case, as shown in FIG. 12A, in the end portions 12a of the photoelectric conversion layer 14 and the second conductive layer 15 to which the portion 13s of the evaporated first conductive layer 13 is attached, a repair line r16 in which only one end portion is removed can be formed.

As the third laser GL3, for example, an IR (InfraRed laser) laser (infrared light laser) can be used. The IR laser is a laser oscillator that oscillates infrared light. The infrared light is light of which the wavelength is longer than 780 nm, and is light, having a large thermal action, which is also called a heat ray. This IR laser includes, for example, a CO₂ laser, or a YAG laser. In the case of the YAG laser, the IR laser light is a fundamental wave (wavelength of 1,064 nm).

Further, as shown in FIG. 12A, the irradiation position of the third laser GL3 is moved in the planar direction of the substrate 11 (direction opposite to that shown in FIG. 11C) as shown by a solid arrow in the same drawing, and the other end portion 12a of the photoelectric conversion layer 14 and the second conductive layer 15 is irradiated with laser light in a pulsed manner, while the third laser GL3 is moved along the longitudinal direction of the compartment element 21 formed in a longitudinal rectangular shape. Meanwhile, this irradiation with the third laser GL3 may be performed on the end portion 12a of the photoelectric conversion layer 14 and the second conductive layer 15 of the compartment element at the side in which at least the structural defect does not exist.

In that case, as shown in FIG. 12B, it is possible to newly form a repair line R16 at which the other end portion 12a of the photoelectric conversion layer 14 and the second conductive layer 15, to which the portion 13s of the evaporated first conductive layer 13 is attached, is also removed. On this occasion, the third laser GL3 is defocused similarly to the above-mentioned first to third defect repairing methods in response to its wavelength, to thereby be in a condition to remove only the photoelectric conversion layer 14 and the second conductive layer 15. For this reason, a portion of the first conductive layer 13 is newly evaporated, and thus a portion of this evaporated first conductive layer 13 is not attached to the repair line R16 once again.

In this way, it is possible to more effectively clean the end portion 12a of the photoelectric conversion layer 14 and the second conductive layer 15 to which the portion 13s of the first conductive layer 13 is attached by evaporation, without generating the burr that causes a portion of the second conductive layer 15 not to be evaporated and remain on the end portion (end portion of the second conductive layer 15) of the repair line. Therefore, the concern is eliminated that the portion 13s of the first conductive layer 13 attached to the wall surface of a portion of the repair line, that is, the end portion 12a of the photoelectric conversion layer 14 and the second conductive layer 15 causes the first conductive layer 13 and the second conductive layer 15 to be short-circuited therebetween, and thus it is possible to prevent the characteristics of the photovoltatic cell from being degraded.

### [Fifth Defect Repairing Method]

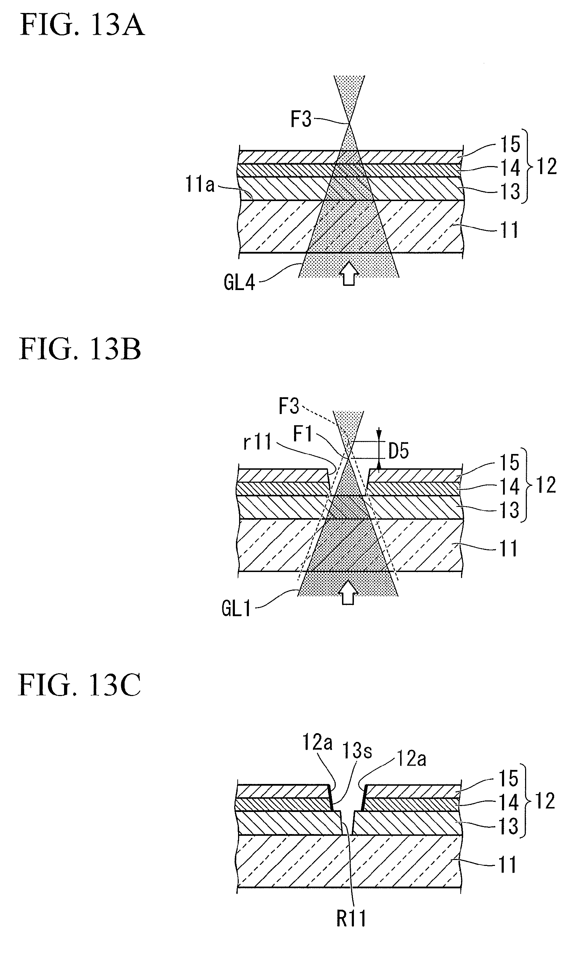

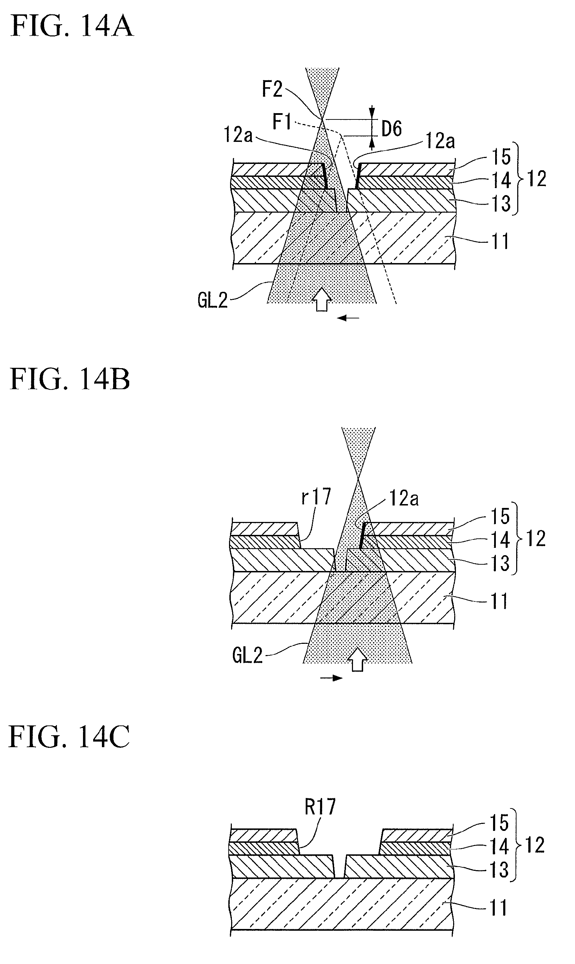

FIGS. 13A to 13C and FIGS. 14A to 14C are diagrams schematically illustrating example steps of forming the repair line R1 for removing or separating a region in which the structural defect exists through two-step laser irradiation, and then cleaning a new structural defect generated in this repair line R11 through new laser irradiation. The structure 12 shown in FIGS. 13A to 13C and FIGS. 14A to 14C is also divided by scribing lines (not shown) into a plurality of compartment elements of which, for example, the outer shape is longitudinally rectangular.

First, as shown in FIG. 13A, the structure 12 is irradiated with the fourth laser GL4 from the substrate 11 side in a pulsed manner. This irradiation with the fourth laser GL4 is performed along the longitudinal direction of the compartment element 21 formed in a longitudinal rectangular shape. The fourth laser GL4 is not particularly limited insofar as it can remove two layers of the photoelectric conversion layer 14 and the second conductive layer 15. For example, an SHG green laser (green laser) can be used as the fourth laser. As shown in FIG. 13A, the fourth laser GL4 is defocused in the first face 11 a side of the substrate 11 so that the focus position F3 thereof is away from the structure 12. Further, the focus position F3 of the fourth laser GL4 is farther from the substrate 11 (structure 12) than the focus position F1 of the first laser GL1 used in post-steps. Meanwhile, the green laser can of course be used as the fourth laser GL4 instead of the SHG laser. In this way, as shown in FIG. 13B, a groove portion r11 at which the photoelectric conversion layer 14 and the second conductive layer 15 are removed can be formed.

Next, as shown in FIG. 13B, while the groove portion r1 1 is irradiated with the first laser GL1 in a pulsed manner, the first laser is moved along the longitudinal direction of the compartment element 21 formed in a longitudinal rectangular shape. On this occasion, the irradiation position of the first laser GL1 is performed without changing from the irradiation position of the fourth laser GL4. As the first laser GL1, a laser obtained by defocusing the fourth laser GL4 is used so that the focus position F3 of the fourth laser GL4 gets close to the substrate 11. That is, the focus position F1 of the first laser GL1 gets closer to the substrate 11 (structure 12) than the focus position F3 of the fourth laser GL4. The defocus distance difference D5 indicating the difference between the focus position F1 of the first laser GL1 and the focus position F3 of the fourth laser GL4 is, for example, 1.0 mm. In this way, as shown in FIG. 13C, the repair line R11 at which three layers constituting the structure 12 (first conductive layer 13, photoelectric conversion layer 14 and second conductive layer 15) are removed can be formed.

However, when the first conductive layer 13 is removed subsequently to the removal of the photoelectric conversion layer 14 and the second conductive layer 15 by the above-mentioned method, the portion 13s of the evaporated first conductive layer 13 is attached, as a residue, to the wall surface of a portion of the repair line R11, that is, the end portion 12a of the photoelectric conversion layer 14 and the second conductive layer 15, which results in a new structural defect. Consequently, as shown in FIG. 14A, while one end portion 12a of the photoelectric conversion layer 14 and the second conductive layer 15 is irradiated with the second laser GL2 in a pulsed manner, the second laser is moved along the longitudinal direction of the compartment element 21 formed in a longitudinal rectangular shape. At the time of this laser irradiation, as shown by a solid arrow in FIG. 11A, the irradiation position of the second laser GL2 is moved in the planar direction of the substrate 11, and the laser irradiation is performed. As the second laser GL2, a laser obtained by defocusing the first laser GL1 is used so that the focus position F1 of the first laser GL1 is away from the substrate 11. That is, the focus position F2 of the second laser GL2 is farther from the substrate 11 (structure 12) than the focus position F1 of the first laser GL1. The defocus distance difference D6 indicating the difference between the focus position F1 of the first laser GL1 and the focus position F2 of the second laser GL2 is, for example, 1.0 mm.

In that case, as shown in FIG. 14B, in the end portions 12a of the photoelectric conversion layer 14 and the second conductive layer 15 to which the portion 13s of the evaporated first conductive layer 13 is attached, a repair line r17 at which only the end portion 12a on one side is removed can be formed. Further, as shown in FIG. 14B, the irradiation position of the second laser GL2 is moved in the planar direction of the substrate 11 (in the planar direction opposite to that shown in FIG. 14A) as shown by a solid arrow in the same drawing, and the other end portion 12a of the photoelectric conversion layer 14 and the second conductive layer 15 is irradiated with laser light in a pulsed manner, while the laser light is moved along the longitudinal direction of the compartment element 21 formed in a longitudinal rectangular shape. Meanwhile, this irradiation with the second laser GL2 may be performed on the end portion 12a of the photoelectric conversion layer 14 and the second conductive layer 15 of the compartment element at the side in which at least the structural defect does not exist.

In that case, as shown in FIG. 14C, it is possible to newly form a repair line R17 at which the other end portion 12a of the photoelectric conversion layer 14 and the second conductive layer 15, to which the portion 13s of the evaporated first conductive layer 13 is attached, is also removed. On this occasion, similarly to the above-mentioned first to third defect repairing methods, the second laser GL2 is in a condition to remove only the photoelectric conversion layer 14 and the second conductive layer 15. Therefore, a portion of the first conductive layer 13 is newly evaporated, and thus a portion of this evaporated first conductive layer 13 is not attached to the repair line R17 once again.

In this way, it is possible to more effectively clean the end portion 12a of the photoelectric conversion layer 14 and the second conductive layer 15 to which the portion 13s of the first conductive layer 13 is attached by evaporation, without generating the burr that causes a portion of the second conductive layer 15 not to be evaporated and remain on the end portion (end portion of the second conductive layer 15) of the repair line. Therefore, the concern is eliminated that the portion 13s of the first conductive layer 13 attached to the wall surface of a portion of the repair line, that is, the end portion 12a of the photoelectric conversion layer 14 and the second conductive layer 15 causes the first conductive layer 13 and the second conductive layer 15 to be short-circuited therebetween, and thus it is possible to prevent the characteristics of the photovoltatic cell from being degraded.

According to such methods of manufacturing of the photovoltatic cell, at the time of removing or separating the locations in which the structural defects are generated, it is possible to reliably insulate the regions in which the structural defects are generated, by removing three layers of the first conductive layer, the photoelectric conversion layer and the second conductive layer, without generation of a new structural defect or remaining of this new structural defect. Consequently, it is possible to repair the locations in which the structural defects are generated, without degrading the characteristics in the photovoltatic cell. While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

## Claims

1. A method of manufacturing a photovoltatic cell, the photovoltatic cell including a substrate, and a structure in which a first conductive layer, a photoelectric conversion layer and a second conductive layer are superposed on the substrate in this order; the structure is electrically separated by a predetermined area to form a plurality of compartment elements; and the compartment elements adjacent to each other are electrically connected to each other, the method comprising:
a defect region specifying step of specifying a region in which a structural defect exists from the plurality of compartment elements; and
a repairing step of irradiating the region or the periphery thereof with a laser beam to remove the structural defect,
wherein the repairing step includes
a step α of irradiating the structure with a first laser to remove or separate the region, and
a step β of irradiating an end portion of the structure generated by the removal or separation with a second laser to clean the end portion, and
wherein the second laser uses a laser obtained by defocusing the first laser so that a focus position thereof is away from the substrate.

2. The method of manufacturing a photovoltatic cell according to claim 1,
wherein the step β includes moving an irradiation position of the second laser in a planar direction of the substrate, and irradiating the end portion of the structure at the side in which the structural defect does not exist with the second laser.

3. The method of manufacturing a photovoltatic cell according to claim 2,
wherein the step β includes performing irradiation with a third laser, different from the first laser in frequency of a laser beam, which is defocused so that a focus position thereof is farther from the substrate than that of the first laser, instead of irradiation with the second laser.

4. The method of manufacturing a photovoltatic cell according to claim 1 or 2, wherein before irradiation with the first laser, the step α further includes a step of irradiating the structure with a fourth laser defocused so that a focus position thereof is farther from the substrate than that of the first laser to form a groove portion, and
wherein after formation of the groove portion, the groove portion of the structure is irradiated with the first laser.
